# EUROPÄISCHE PATENTSCHRIFT

(11) **EP 0 752 294 B1**
(45) Veröffentlichungstag und Bekanntmachung des Hinweises auf die Patenterteilung: **21.06.2000**
(21) Anmeldenummer: 96110030.2
(22) Anmeldetag: 21.06.1996
(51) Int. Cl.: B23K 3/06, H05K 3/34, H01L 21/60

(54) **Verfahren und Einrichtung zum Austragen von flüssigem Lot**
Method and apparatus for applying liquid solder
Méthode et appareil d'applicage de plomb liquide

(30) Priorität: 01.07.1995 CH 192695
(43) Veröffentlichungstag der Anmeldung: 08.01.1997
(60) Teilanmeldung: 99113056.8
(73) Patentinhaber: ESEC SA, CH-6330 Cham/Steinhausen (CH)
(72) Erfinder: Lüchinger, Christoph, Dr., 6403 Küssnacht a.R. (CH); Suter, Guido, 6331 Hünenberg (CH)
(74) Vertreter: Falk, Urs

(56) Entgegenhaltungen:
- AT-B- 291 716
- DE-A- 4 136 723
- US-A- 2 875 719
- US-A- 4 527 717
- US-A- 5 364 011

## Beschreibung

Die Erfindung betrifft ein Verfahren zum Austragen von flüssigem Lot in einzelnen Portionen gemäss dem Oberbegriff des Anspruches 1 und eine Einrichtung zur Durchführung des Verfahrens gemäß Oberbegriff des Anspruches 11.

Lötverfahren dieser Art werden typischerweise - jedoch nicht ausschliesslich - bei der Montage von Halbleiter-Elementen (Chips) auf einem metallischen Träger (lead frame) angewendet. Hauptsächlich Leistungshalbleiter werden in der Regel mit dem Substrat (üblicherweise Kupfer) mittels Weichlötung verbunden, um über die Lötverbindung eine (im Vergleich zur Montage mittels Klebstoff) wirksame Ableitung der beim Betrieb entstehenden Verlustwärme aus dem Halbleiter-Chip zu gewährleisten. Allerdings werden, vor allem bei gesteigerter Leistungsdichte, hohe Anforderungen an die Homogenität der Lötverbindung gestellt, d.h. es werden definierte Dicke, gleichmässige Verteilung und einwandfreie Benetzung der Lotschicht über die ganze Chipfläche, bzw. völlige Blasenfreiheit sowie Reinheit der Lötstelle verlangt; andererseits soll aber das Lot möglichst nicht aus dem Lotspalt seitlich austreten und sich neben dem Chip ausbreiten, was wiederum eine genaue Dosierung und Positionierung der LotPortionen erfordert.

Es sind im Anwendungsbereich der Chip-Montage hauptsächlich zwei Lötverfahren bekannt und im praktischen Einsatz. Im einen Fall wird das Ende eines Lötmetall-Drahtes mit dem über die Schmelztemperatur des Lotes erhitzten Substrat in Berührung gebracht, um ein Stück des Drahtes abzuschmelzen. Dieses Verfahren ist aufgrund seiner Einfachheit und Flexibilität für die Massenproduktion an sich gut geeignet. Jedoch hängt der Schmelzvorgang, vor allem das Volumen und die Positionierung der Lotportion, sehr stark von der Materialpaarung und den Oberflächeneigenschaften des Substrats ab, d.h. die Menge und Position des jeweils abschmelzenden Lotes sind erheblichen Streuungen unterworfen. Zudem ist die entstehende, etwa kreisförmige Benetzungsfläche schlecht an die rechteckige oder quadratische Gestalt der Chips angepasst.

Das zweite bekannte Verfahren besteht darin, dass flache Formlinge aus Lötmetall, deren Abmessungen auf die Chips abgestimmt sind, vorfabriziert werden (sogen. "solder preform"); die Formlinge werden dann auf das Substrat aufgelegt und von diesem aufgeschmolzen, um eine Lotschicht in den verlangten Dimensionen zu bilden (US-A 4,577,398 und US-A 4,709,849). Wegen der erforderlichen Vorfabrikation der Lot-Formlinge und den zusätzlichen Montageoperationen ist diese Methode allerdings recht kostspielig und wenig flexibel. Bei beiden vorerwähnten Verfahren muss übrigens die Schmelzwärme dem Lot über das Substrat zugeführt werden, was eine entsprechende Ueberhitzung desselben erfordert und eine gewisse Zeit in Anspruch nimmt, wobei die Wahl der Substrat-Temperatur eingeschränkt ist.

Schliesslich ist in der US-A 4,527,717 eine Apparatur zum Dosieren von flüssigen Lotportionen beschrieben. Hierbei wird eine grössere Menge Lötmetall in einem beheizten Tiegel dauernd schmelzflüssig gehalten. Im Boden des Tiegels sind übereinander ein Stopfenventil und ein Dosierkolben - je mit zugeordnetem Hubmechanismus - angeordnet. Durch abwechselnde Betätigung von Ventil und Kolben können aus dem Schmelzevorrat abgemessene LotPortionen abgezogen werden. Ein solcher Ventil-Kolben-Mechanismus ist für kurze Taktzeiten wenig geeignet und lässt kaum eine Anpassung des Portionen-Volumens zu. Abgesehen vom hohen Energiebedarf für den Schmelzevorrat scheint auch die Tauglichkeit der Einrichtung für Dauerbetrieb fraglich.

Bei Handlötkolben und ähnlichen Lötgeräten ist es - im Sinne des Oberbegriffes des Anspruches 1 - auch bekannt, das drahtförmige Lot in einer Führungsanordnung des Gerätes durch eine Längsbohrung zu der auf Schmelztemperatur aufgeheizten, durchbohrten Lötspitze schrittweise vorzuschieben und dabei schmelzflüssig durch eine verengte Austrittsmündung an der Lötspitze auszustossen oder durch Kapillarwirkung ausfliessen zu lassen (z.B. DE-C-37 34 550, die als nächstliegender Stand der Technik anzusehen ist, sowie DE-A-36 12 341, AT 291 716, US 2,875,719). Das Lot wird dabei in der Lötspitze selbst aufgeschmolzen, wobei die jeweilige Schmelzemenge unbestimmt ist. Beim Beheizen der Lötspitze ist der Wärmefluss generell von hinten gegen die Spitze hin gerichtet, und an die Lötspitze bzw. an die Wärmequelle rückwärts anschliessend sind im allgemeinen wärmeisolierende Führungshülsen angeordnet, um den Wärmeabfluss nach hinten zu hemmen.

Ausgehend von diesem Stand der Technik sollen mit der vorliegenden Erfindung die vorerwähnten Nachteile bekannter Anordnungen überwunden werden. Insbesondere ist es eine Aufgabe der Erfindung, ein speziell für die Anwendung bei der Chipmontage taugliches Verfahren und eine Einrichtung zum portionenweisen Austragen von flüssigem Weichlot vorzuschlagen, mit dem das Dosieren der Lotportionen über einen grossen Gewichts- bzw. Volumenbereich mit hoher Genauigkeit und Zuverlässigkeit möglich ist. Dabei sollen, entsprechend den Anforderungen moderner Massenproduktion, kurze Taktzeiten sowie hohe Flexibilität beim Umrüsten erreicht werden.

Diese Aufgabe wird erfindungsgemäss mit einem Verfahren nach Patentanspruch 1 und einer Einrichtung nach Patentanspruch 11 gelöst. Verschiedene vorteilhafte Varianten der Erfindung sind in den abhängigen Ansprüchen 2 - 10 (Verfahren) bzw. 12 - 18 (Einrichtung) angegeben.

Die Vorteile der Erfindung werden vor allem darin gesehen, dass es sich praktisch um ein "Eintakt"-Verfahren mit einfachen Hubbewegungen handelt, das hohe Taktraten erlaubt. Die Austragleistung ist dabei im wesentlichen nur durch die Heizleistung zum Aufschmelzen des Lots begrenzt, welche Leistung selbsttätig und unabhängig vom Substrat regelbar ist. Die konstant geregelte Heiztemperatur wird natürlich der jeweils verwendeten Lotlegierung angepasst.Indem am Übergang zwischen dem beheizten und dem gekühlten Bereich des Führungsrohres ein möglichst grosser Temperaturgradient aufrechterhalten wird, lassen sich konstante Ausgangsbedingungen für den taktweisen Lotaustrag schaffen, insbesondere ein gleichbleibender metallostatischer Druck über der verengten Austrittsmündung. Damit wird erreicht, dass die Dosiergenauigkeit praktisch nur von der Genauigkeit des Lotdraht-Vorschubes abhängt, und dass - im Rahmen des gegebenen Schmelzevorrates in der Bohrung des Führungsrohres - die Portionengrösse innerhalb weiter Grenzen variiert werden kann. Die Verwendung eines Formstempels beim Auftragen der Lotportionen auf ein Substrat ermöglicht zudem, Portionen mit definierter Flächenausdehnung und Dicke zu erzeugen. Überdies ermöglicht die Erfindung, selbst auf einem vom Lot schlecht benetzbaren oder auch weniger hoch erhitzten Substrat dosierte Lotportionen von bestimmter Menge und reproduzierbarer Gestalt aufzutragen.

Nachstehend werden verschiedene Ausführungsbeispiele der Erfindung im Zusammenhang mit der Zeichnung näher erläutert, wobei die Anwendung bei der Montage von Halbleiter-Chips auf einem metallischen Substrat im Vordergrund steht.
- Fig. 1: zeigt im Vertikalschnitt und teilweise schematisch ein erstes Beispiel einer Einrichtung mit Formstempel zum Weichlöten von Halbleiter-Chips auf einem metallischen Substrat,
- Fig. 2: ist ein Horizontalschnitt auf der Höhe der Linie II-II in Fig. 1,
- Fig. 3: veranschaulicht in grösserem Massstab den in Fig. 1 mit III bezeichneten Uebergangsbereich zwischem festem und geschmolzenem Lot,
- Fig. 4: ist ein zur Fig. 3 gehöriges Temperaturdiagramm,
- Fig. 5: zeigt die Ansicht von unten des bei der Einrichtung nach Fig. 1 verwendeten Formstempels,
- Fig. 6: ist die teilweise geschnittene Seitenansicht und
- Fig. 7: die Draufsicht des gleichen Formstempels,
- Fig. 8: zeigt im Schnitt den auf dem Substrat aufliegenden Formstempel mit in den Formhohlraum ausgestossener Lotportion,
- Fig. 9: zeigt ein weiteres Ausführungsbeispiel einer Einrichtung zum Weichlöten, im Vertikalschnitt ähnlich der Fig. 1, und
- Fig. 10: zeigt - als Detail der Fig. 9 im grösseren Massstab - eine besondere Ausführung der verengten Austrittsmündung.

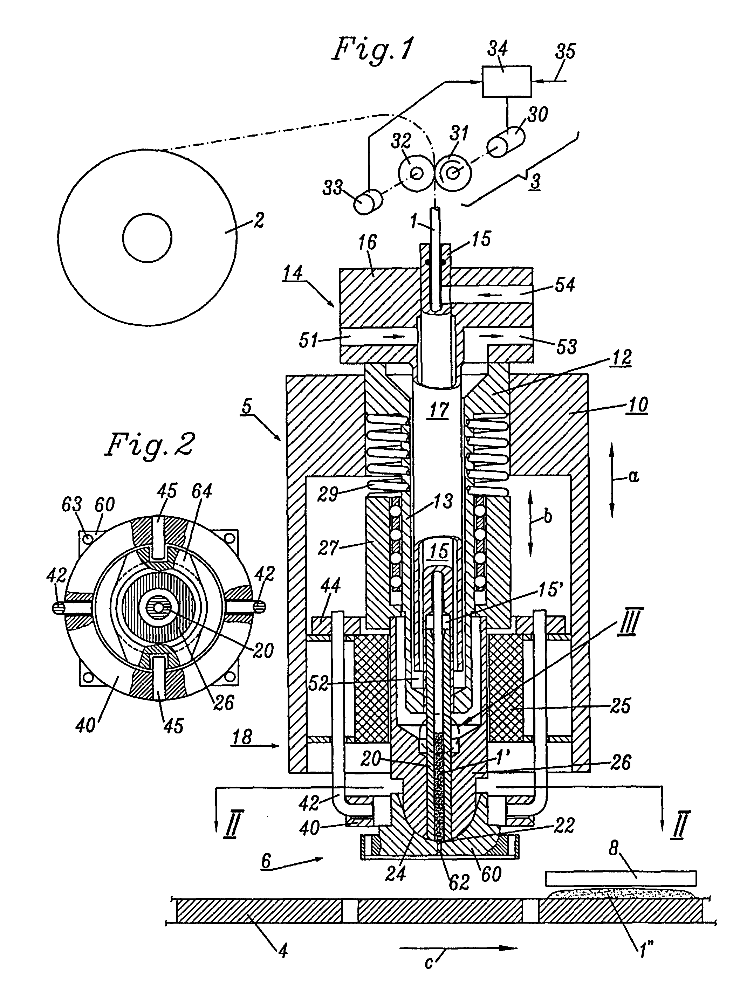

Die in Fig. 1 als Ganzes dargestellte, beispielsweise Anordnung dient dazu, auf ein metallisches, streifenförmiges Substrat 4 (lead frame), das in Richtung des Pfeiles c schrittweise weitertransportiert wird, Halbleiter-Chips 8 mittels Weichlot aufzulöten. Ein Lötmetall-Draht 1 (Durchmesser z.B. 1 mm oder 0,76 mm) wird von einer Spule 2 abgezogen, mit Hilfe von Antriebsmitteln 3 von oben nach unten durch eine Einrichtung 5 längsgeführt vorgeschoben und in deren unterem Bereich aufgeschmolzen. Die Einrichtung 5 ist als Ganzes heb- und senkbar (Pfeil a). Der Austrag von flüssigem Lot 1' erfolgt in einzelnen Portionen durch schrittweise Betätigung des Antriebs 3, beim vorliegenden Beispiel über einen Formstempel 6 jeweils bei abgesenkter, mit dem Formstempel auf dem Substrat 4 aufliegender Einrichtung 5 (siehe Fig. 8). Das beheizte, metallische Substrat 4 wird dabei vom Lot benetzt. Die Einrichtung 5 wird hierauf angehoben und das Substrat 4 mit der übernommenen Lotportion 1" weitertransportiert, worauf, wie nur schematisch angedeutet, ein Chip 8 auf die noch flüssige Lotportion 1" plaziert wird.

Die etwa vertikal stehende Einrichtung 5 besteht im wesentlichen aus einem rohrförmigen Gehäuse 10, einem Führungsteil 12, einem Anschlussteil 14, einer Schmelzeinheit 18 mit Formstempel 6, sowie dem Antrieb 3. Der Führungsteil 12 und der Anschlussteil 14 sind im Gehäuse 10 fest eingebaut. Die Schmelzeinheit 18 zusammen mit dem Formstempel 6 kann dagegen entlang dem Führungsteil 12 einen gewissen Vertikalhub ausführen (Pfeil b).

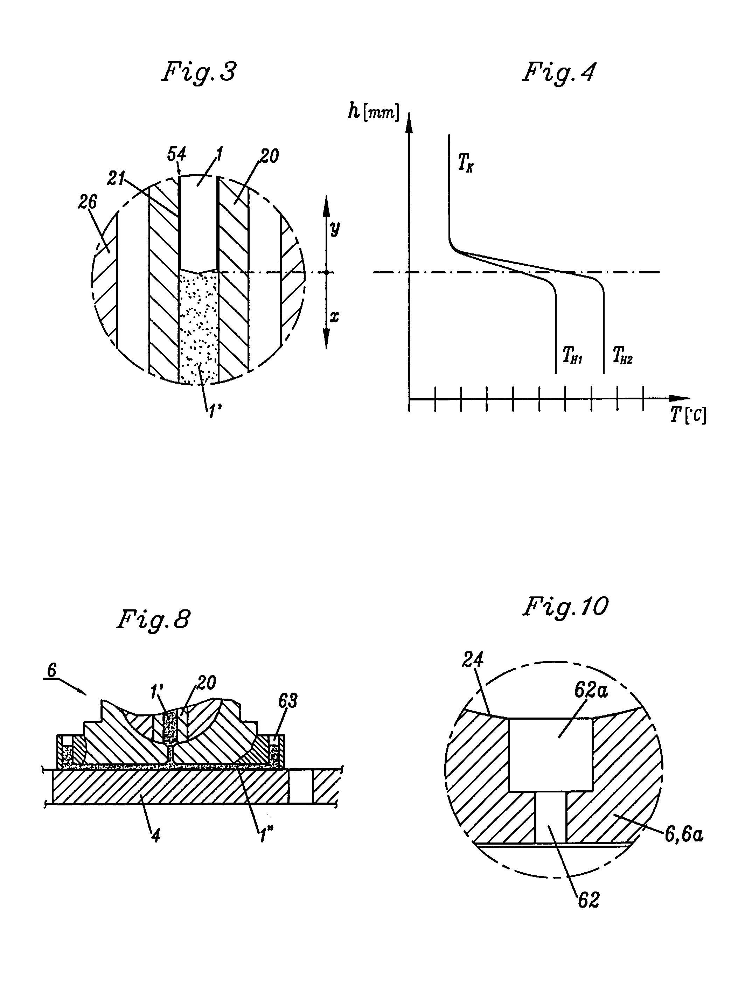

Der Führungsteil 12 weist ein nach unten ragendes Rohr 13 auf. Innerhalb des Rohres 13 befinden sich zwei weitere, konzentrische Rohre 15 und 17, die vom Kopf 16 des Anschlussteils 14 ausgehen. Die unteren Enden der Rohre 15 und 13 sind aneinander zentriert. Durch die Längsbohrung des inneren Rohres 15 erstreckt sich das feste Lot 1. Ein unterer Abschnitt 15' dieser Längsbohrung ist erweitert, um ein Führungsrohr 20, welches zur Schmelzeinheit 18 gehört, gleitend aufzunehmen. Die Längsbohrung 21 (Fig. 3) des Führungsrohres 20 reicht bis zum Austrittsende 22 und ist dem Durchmesser des festen, draht- oder stangenförmigen Weichlots 1 angepasst (höchstens etwa 5-10 % Uebermass).

Die Schmelzeinheit 18 ist von einer im Innern des Gehäuses 10 fest montierten, ringförmigen, elektrischen Heizung 25 umgeben. Sie erhitzt berührungslos einen zylindrischen Tiegel 26, dessen oberes Ende von einer Hülse 27 gehalten ist. Die letztere ist über eine Kugelführung am Rohr 13 verschiebbar geführt. Tiegel 26 und Führungsrohr 20 sind an ihren unteren Enden miteinander fest verbunden.

Von der Heizung 25 wird der Tiegel 26 und von diesem ein unterer Bereich (x in Fig. 3) des vertikalen Führungsrohres 20 einschliesslich des unteren Rohrendes 22 zum Aufschmelzen des Lots aufgeheizt, so dass sich in der Bohrung 21 unten im Rohr 20 schmelzflüssiges Lot 1' befindet. Die Temperatur im aufgeheizten, unteren Bereich des Rohres 20 wird im allgemeinen höher sein als die Liquidustemperatur des Lotmaterials, so dass das Lot dann vollständig geschmolzen wird; es können jedoch gewisse Lotlegierungen auch bei Temperaturen unterhalb Liquidustemperatur verarbeitet werden, bei denen das Lotmaterial nur teilweise schmelzflüssig ist (Fest/Flüssig-Gemisch). Dieser letztere Fall soll demnach immer mit eingeschlossen sein, auch wenn im folgenden einfach von "schmelzflüssig" oder "Schmelze" die Rede ist. Wie noch näher ausgeführt wird, kann jeweils durch Betätigung des Antriebs 3 bzw. Vorschub des festen Lots 1 im Führungsrohr 20 eine Portion von flüssigem Lot 1' unten aus der Bohrung 21 ausgestossen werden. Der Ausstoss erfolgt im vorliegenden Fall in den Formstempel 6 über dessen Eingusskanal 62, der eine an die Bohrung 21 anschliessende, verengte Austrittsmündung bildet.

Ein oberer, an den beheizten Bereich x anschliessender Bereich (y in Fig. 3) des Rohres 20 wird intensiv auf eine Temperatur deutlich unterhalb der Solidustemperatur des Lotmaterials gekühlt. Zu diesem Zweck enthält der Anschlussteil 14 eine Anordnung zur Zirkulation eines geeigneten Kühlmediums, z.B. Pressluft. Das Kühlmedium wird durch einen Kanal 51 zugeführt, strömt dann in der Bohrung des Rohres 17 aussen am Rohr 15 entlang nach unten bis zu einem Ringkanal 52 und von dort aussen am Rohr 17 entlang wieder nach oben zum Austrittskanal 53. Dabei wird über den dünnwandigen unteren Abschnitt des Rohres 15 das Führungsrohr 20 im oberen Bereich y gekühlt, vorzugsweise mit konstant geregelter Kühlleistung.

In Fig. 3 ist der Uebergang im Führungsrohr 20 zwischen dem unteren, beheizten Bereich x, in welchem das Führungsrohr 20 schmelzflüssiges Lot 1' enthält und dem oberen, gekühlten Bereich y, in welchem das Lot 1 noch fest ist, vergrössert dargestellt. Das Diagramm Fig. 4 zeigt den zugehörigen Temperaturverlauf T als Funktion der Höhe h in der betreffenden Übergangszone des Rohres 20. Wie ersichtlich, wird ein steiler Temperaturübergang zwischen den Zonen x (Temperaturen T_{H1}, T_{H2}) und y (Temperatur T_{K}) erzeugt. Die über den Tiegel 26 stattfindende Beheizung des Führungsrohrs wird thermostatisch geregelt, z.B. mit einem (nicht dargestellten) Temperaturfühler im unteren Bereich des Tiegels. Dabei können entsprechend dem jeweils verwendeten Lot verschiedene Temperaturen T_{H1}, T_{H2} im Bereich x eingestellt werden, wobei die Höhenlage des Temperaturübergangs sich nur geringfügig verschiebt. Typische Liquidustemperaturen der zu verarbeitenden Weichlot-Legierungen liegen zwischen etwa 150° und 410°C. Zum einwandfreien Schmelzen und Austragen des Lots ist meist eine gewisse Ueberhitzung des Tiegels und des Rohres auf eine Arbeitstemperatur T_{H} z.B. bis gegen 450°C erforderlich. Im allgemeinen wird also T_{H} höher gewählt als die Liquidustemperatur des Lotes, es gibt jedoch, wie erwähnt, auch Lote, die nicht vollständig aufgeschmolzen verarbeitet werden (T_{H} innerhalb des Schmelzintervalls der Lotlegierung).

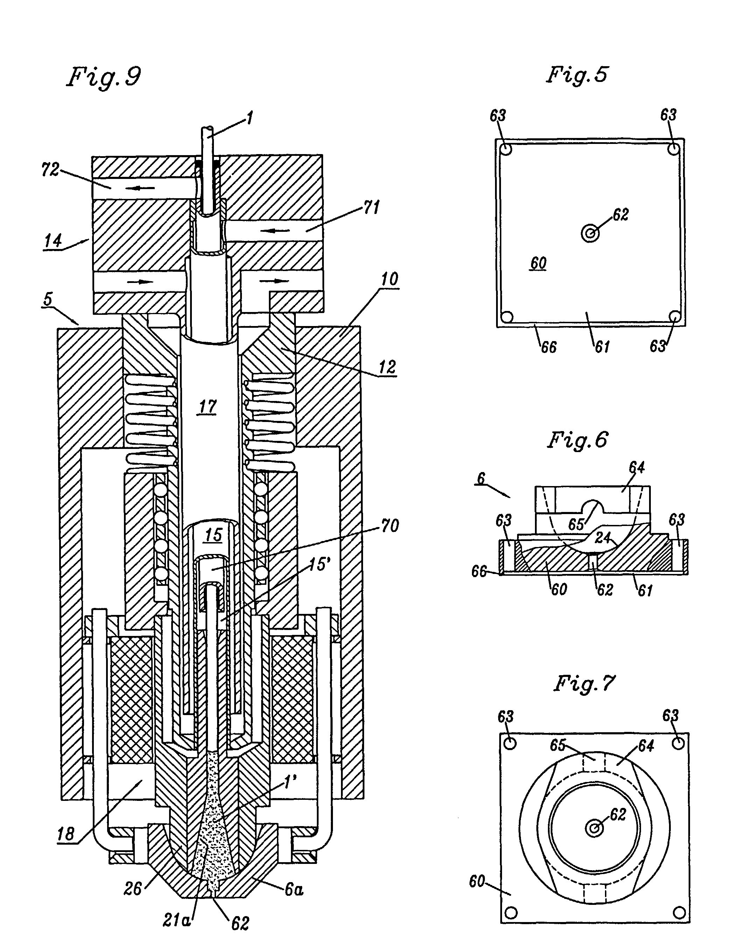

Der Temperaturübergang durch das Zusammenwirken von (geregelter) Heizung und Kühlung erweist sich im Betrieb als sehr lagestabil. Der Füllstand der Schmelze in der Bohrung 21 und damit die Schmelzemenge, die jeweils vor dem Ausstossen bereitsteht, werden auf diese Weise kontrolliert. Die verengte Austrittsmündung 62 ermöglicht dabei das Halten der Schmelze, auch wenn dafür die Kapillarwirkung in der Bohrung 21 und die Kohäsion der Schmelze nicht ausreichen würden. Über die verengte Mündung 62 wird weiter unten anhand der Fig. 9 und 10 noch weiteres ausgeführt.

Beim Vorschub des festen Lots 1 wirkt dieses in der Bohrung 21 gewissermassen als Kolben auf das flüssige Lot 1'. Der vorgeschobene, feste Abschnitt wird unmittelbar wieder bis zur Höhe des lagestabilen Temperaturübergangs aufgeschmolzen. Die Heizleistung richtet sich im wesentlichen nach der beim Betrieb pro Zeiteinheit auszutragenden Lotmenge. Am Ende des festen Drahtabschnittes stellt sich beim Ausstossvorgang selbsttätig eine gewisse Dichtwirkung ein, indem etwa in den Führungsspalt zwischen Draht und Bohrungswand eindringende Schmelze sogleich erstarrt und am Draht mitgeschoben wird. Als Folge dieser Dichtwirkung im Bereich des grossen Temperaturgradienten zwischen den Zonen x und y können auf das flüssige Lot 1' erhebliche Pumpdrücke ausgeübt werden.

Zweckmässigerweise wird in der Bohrung 21 des Führungsrohrs 20 eine Schutzgas- oder Formiergas-Atmosphäre aufrecht erhalten, die bis zum aufgeschmolzenen Lot 1' reicht. Hierfür dient gemäss Fig. 1 ein Gasanschluss 54 im Kopf 16 des Anschlussteils. Das Schutzgas oder Formiergas gelangt entlang dem Lotdraht 1 zur erweiterten Bohrung 15' im Rohr 15 und von dort weiter im Ringspalt der Bohrung 21 bis zur Schmelze 1' (Fig. 3). Als Schutzgas kann z.B. Stickstoff oder Argon verwendet werden. Als Formiergas dient ein reaktives, desoxidierendes Gas, beispielsweise ein Wasserstoff-Stickstoff-Gemisch; es hat den Zweck, das flüssige Lot und die Bohrung 21 von störenden Oxiden freizuhalten.

Die Antriebsmittel 3 zum schrittweisen Vorschub des draht- oder stangenförmigen Lots 1 weisen gemäss Fig. 1 eine Antriebsrolle 31 und eine Tastrolle 32 auf, zwischen denen das Lot hindurchgeführt wird. Mit der Antriebsrolle 31 ist ein Motor 30, zweckmässigerweise ein Schrittmotor, verbunden, der ein Vorschubsignal von einem Regler 34 erhält. Das Vorschubsignal wird im Regler abgeleitet einerseits von einem Eingangssignal 35, das der jeweils auszustossenden Lotmenge als Sollwert entspricht, und anderseits einem Wegmessignal als Istwert des Vorschubweges, erzeugt von einem Drehgeber (Encoder) 33, der mit der Tastrolle 32 verbunden ist. Da ein konstanter Querschnitt des verwendeten festen Lots vorausgesetzt werden kann, entspricht ein bestimmter Vorschubweg des Lotdrahtes 1 genau einem bestimmten Volumen der durch die Austrittsmündung 22 ausgestossenen, flüssigen Lotportion.

Wie weiter oben erwähnt, werden mit der dargestellten Einrichtung die Lotportionen über einen an das Führungsrohr 20 anschliessenden Formstempel 6 auf das Substrat 4 übertragen. Das Rohr 20 und der Tiegel 26 einerseits und der Körper 60 des Formstempels anderseits berühren einander entlang einer Kugelfläche 24, in der die Mündung 22 enthalten ist. Der Formstempel 6 wird mittels kardanischer Lagerung, wie sie insbesondere aus Fig. 2 ersichtlich ist, in Berührung mit der Kugelfläche 24 gehalten. Ein Kardanring 40 ist auf einem Ringdurchmesser an zwei Stangen 42 schwenkbar gehalten, die sich nach oben in das Gehäuse 10 erstrecken und in einem Tragring 44 festsitzen; der Tragring 44 liegt am Gehäuse lose auf. Auf einem zu den Stangen 42 um 90° versetzten Durchmesser des Kardanringes 40 befinden sich zwei nach innen ragende Lagerstifte 45. Auf diesen liegt ein oben am Körper 60 des Formstempels angebrachter Kragen 64 mit entsprechenden Halbrund-Einschnitten 65 auf (siehe auch Fig. 6 und 7). Dank dieser Lagerung ist der Formstempel über der Kugelfläche 24 allseitig schwenkbar, um sich beim Absenken auf das Substrat 4 an dessen Oberseite genau anzuschmiegen. Eine vorgespannte Druckfeder 29 über der Hülse 27 erzeugt einen stetigen Kontaktdruck an der Kugelfläche 24, wodurch der Formstempel 6 jeweils nach dem Abheben seine Lage beibehält und eine gute Dichtwirkung gegen den Austritt von Lot am Übergang vom Rohr 20 in die Bohrung 62 des Formstempels 6 erzielt wird.

Es können auch verschiedene Formstempel leicht gegeneinander ausgetauscht werden. Der jeweils eingesetzte Formstempel wird zu diesem Zweck angehoben, wobei über den Tiegel 26 und die Hülse 27 die Druckfeder 29 zusammengedrückt wird. Durch Drehen des angehobenen Formstempels um 90° wird dann der Kragen 64 über die Lagerstifte 45 hinweggedreht, bis die Rillen 65 etwa mit den Stangen 42 fluchten und der Formstempel nach unten herausgenommen werden kann. Auf analoge Weise wird ein neuer Formstempel eingesetzt, wobei die Konstruktion eine hohe Lagegenauigkeit desselben sicherstellt, so dass nach dem Austausch des Formstempels kein Justieren notwendig ist. Ausser dem Formstempel 6 sind der Tiegel 26 zusammen mit dem Rohr 20 die einzigen Teile der Einrichtung, die mit flüssigem Lot in Kontakt treten und deshalb einer gewissen Verschmutzung ausgesetzt sein können. Die dargestellte Konstruktion erlaubt jedoch vorteilhafterweise ein einfaches, rasches und reproduzierbares Auswechseln auch des Tiegels 26 mit dem Rohr 20.

Vom Tiegel 26 aus wird der Formstempel 6 über die Kugelfläche 24 ebenfalls auf die Arbeitstemperatur T_{H} des Lots beheizt. Der Formstempel - wie auch der Tiegel 26 und das Führungsrohr 20 - sind aus einem Material gefertigt, das vom geschmolzenen Lot 1' nicht benetzbar ist. Geeignete Werkstoffe sind z.B. Graphit, Keramik, Glas oder auch rostfreier Stahl und Titan.

Aus den Fig. 5, 6 und 7 sind weitere vorteilhafte Gestaltungsmerkmale des Formstempels, insbesondere bezüglich seines Formhohlraumes, ersichtlich. Der Formhohlraum 61 des Formstempels befindet sich an der Unterseites des Körpers 60, wird durch einen Auflagerand 66 begrenzt und ist nach unten gegen das Substrat hin offen. Ueber einen von der Kugelfläche 24 ausgehenden, relativ engen Eingusskanal 62 kommuniziert der Formhohlraum 61 mit der Austrittsmündung 22 am Führungsrohr 20. Im Körper 60 des Formstempels sind Steigerkanäle 63 vorhanden, die vom Hohlraum 61 ausgehen und nach oben offen sind. Vorzugsweise befinden sich solche Steigerkanäle, wie dargestellt, in den Ecken bzw. in Randbereichen des Formhohlraumes, um die vollständige und rasche Formfüllung zu gewährleisten; selbstverständlich wird die Anordnung von Steigerkanälen entsprechend der jeweiligen Geometrie des Formhohlraums gewählt. Die Flächenausdehnung des Formhohlraums wiederum richtet sich nach derjenigen der aufzulötenden Chips. Die aufgetragenen, schmelzflüssigen Lotportionen werden (wie an sich bekannt) beim anschliessenden Aufbringen des Chips von diesem im Lotspalt "gequetscht" bis zur vollflächigen Benetzung des Chips und des Substrats.

Bei Betriebsbereitschaft der dargestellten Einrichtung steht im unteren Bereich x des Führungsrohres 20 ein bestimmter Vorrat an flüssigem Lot 1' bereit. Infolge Kapillarwirkung in der Bohrung 21 und insbesondere im verengten Kanal 62 fliesst dieses nicht von selbst aus. Die Einrichtung wird nun abgesenkt (Pfeil a) bis zum Aufsitzen des Formstempels 6 auf dem Substrat 4. Dieses Absenken erfolgt mit einem kleinen Ueberhub, so dass die Feder 29 etwas zusammengedrückt und der Ring 44 abgehoben wird. Die Feder 29 dämpft auch den Schlag des auf das Substrat auftreffenden Formstempels. Dabei passt sich der kardanisch gelagerte Formstempel 6 unter der Federwirkung einer allfälligen, geringen Schieflage des Substrats 4 genau an und der Auflagerand 66 schliesst den Formhohlraum 61 dicht ab. Durch den Ueberhub werden auch gewisse Toleranzen in der Höhenlage des Substrats und in der Fertigungshöhe der Formstempel überbrückt.

Spätestens nach dem Aufsetzen des Formstempels wird der Vorschub des festen Lotes 1 durch ein Startsignal 35 (Sollwert des Vorschubweges) ausgelöst und damit eine entsprechende, abgemessene Portion des flüssigen Lots durch die Mündung 22 in den Formhohlraum 61 ausgestossen, wobei die vorhandene Luft über die Kanäle 63 entweicht. Nachdem der Hohlraum 61 gefüllt ist, steigt flüssiges Lot auch in die Kanäle 63 auf, wie in Fig. 8 dargestellt ist.

Zusätzliche Vorteile können dadurch erzielt werden, dass man den Lot-Ausstoss (Beginn des Startsignals 35) bereits etwas vor dem Auftreffen des Formstempels 6 auf dem Substrat 4 beginnen lässt: Einerseits kann so die Taktzeit insgesamt verkürzt werden, indem sich die Zeitabschnitte für das Absenken und für den Lot-Ausstoss teilweise überlappen. Vor allem aber kann der bereits ausgestossene Lottropfen - bei noch bestehendem Abstand des Formstempels über dem Substrat - sich bereits seitlich über einen erheblichen Teil der Formfläche ausbreiten und das Substrat benetzen, unbehindert durch die im allgemeinen sehr geringe Höhe des Formhohlraums 61 (die Tiefe der Ausnehmung 61 im Körper 60 ist zumeist wesentlich geringer, als in den Fig. 1, 6 und 8 zwecks deutlicherer Darstellung gezeichnet). Das seitliche Ausbreiten des flüssigen Lots bis zu den Rändern des Formhohlraumes setzt sich fort, während der Formstempel vollends auf das Substrat aufgesetzt wird.

Eine Wirkung der Steigerkanäle 63 - Sicherstellung der vollständigen Formfüllung - wurde weiter oben bereits erwähnt. Es ist vorteilhaft, das durch die Kanäle 63 gebildete (im Vergleich mit dem Volumen des Formhohlraums 61 erhebliche) Speichervolumen gezielt auszunutzen, indem man die Höhe des Raumes 61 etwas geringer wählt als zur Erzeugung der verlangten Lot-Schichtdicke (nach Montage des Chips) erforderlich wäre. Ein beträchtlicher Teil der benötigten Lotportion gelangt dann (bei aufsitzendem Formstempel, Fig. 8) zwangsläufig in die Steigerkanäle, wobei mit sehr grosser Sicherheit, selbst bei gewissen Variationen des ausgestossenen Volumens, auch die Ecken und Ränder der Formfläche benetzt werden. Beim anschliessenden Abheben des Formstempels 6 fliesst die in den Kanälen 63 gespeicherte Lotmenge sogleich zurück und verteilt sich über der benetzten Fläche. Schliesslich kann auch der Lotvorschub bzw. die Portionengrösse im Rahmen des Speichervolumens der Steigerkanäle 63 variiert werden, um mit einem und demselben Formstempel 6 entsprechend unterschiedliche End-Schichtdicken im Lotspalt zu erzielen.

Nach beendetem Lotvorschub und Ausstossen der Lotportion wird sogleich die Einrichtung 5 vom Substrat abgehoben. Das flüssige Lot bleibt auf dem Substrat haften und reisst im Kanal 62 unter der Mündung 22 ab; das in den Kanälen 63 vorhandene Flüssiglot verteilt sich, wie erwähnt, über der vom Lot benetzten Fläche. Das beheizte Substrat 4 wird dann in bekannter Weise einen Schritt vorgeschoben (Pfeil c), so dass ein neues Substratfeld unter die Einrichtung gelangt und ein Chip 8 auf die eben aufgetragene, noch flüssige Lotportion 1'' plaziert werden kann. Es kann nun ein neuer Arbeitszyklus beginnen.

Grundsätzlich ist es auch möglich, mit einem einzigen Formstempel zwei oder mehrere voneinander getrennte Lotportionen nebeneinander im gleichen Takt auf die selbe Substratfläche auszutragen, jede Portion mit definierter Flächenausdehnung und in genauer Position. Hierfür wird ein Formstempel mit den den benötigten Lotportionen entsprechenden, separaten Formhohlräumen verwendet (nicht dargestellt). Jeder dieser Formhohlräume wird über einen eigenen, von der Mündung 22 ausgehenden Kanal gespeist. Eine Aufteilung der im selben Takt ausgestossenen Gesamt-Lotmenge in Teilportionen entsprechend unterschiedlichen Volumina der einzelnen Formhohlräume kann durch Anpassen der Strömungswiderstände (Durchmesser und Länge) der erwähnten Kanäle erreicht werden.

Schliesslich ist es nach dem erfindungsgemässen Verfahren, jedoch in Abweichung von der dargestellten und oben beschriebenen Einrichtung auch möglich, abgemessene Lotportionen ohne Verwendung eines Formstempels auf ein Substrat aufzutragen. Hierbei wird (gemäss einer ersten Variante) jeweils an der verengten Austrittsmündung ein Tropfen flüssigen Lots durch entsprechenden Vorschub des festen Lotstabes gebildet, worauf man Mündung und Substrat einander annähert, bis der Tropfen das Substrat berührt und von diesem aufgenommen wird. Zwar wird auf diese Weise nicht eine bestimmte, durch einen Formhohlraum vorgegebene Flächengestalt erzeugt, doch können dabei ebenfalls genau abgemessene Lotportionen in rascher Folge ausgetragen und genau positioniert werden.

Eine weitere Verfahrensvariante ohne Verwendung eines Formstempels besteht darin, dass man das feste Lot impulsartig zur verengten Mündung hin vorschiebt, um flüssige Lotportionen strahlartig gegen das Substrat auszustossen. Unter gewissen Verhältnissen beim Ausstossen (kurze Impulsdauer und ausreichender Abstand der Mündung vom Substrat) wird sich die Lotportion nach Verlassen der Mündung zu einem freien Tropfen bzw. zu einer Kugel formen. Eine besondere Anwendung bzw. Erweiterung dieser Verfahrensvariante kann darin bestehen, dass der Lotausstoss mit einer seitlichen Fahrbewegung der Mündung auf einer bestimmten Höhe über dem Substrat synchronisiert wird. Auf diese Weise kann ein der Fahrbewegung entsprechendes Lotmuster auf das Substrat "geschrieben" werden. Auch hierbei bleiben die Verfahrensvorteile einer genauen Volumendosierung und der exakten Positionierung der Lotportion auf dem Substrat erhalten.

Die in Fig. 9 dargestellte Einrichtungs-Variante entspricht im generellen Aufbau derjenigen nach Fig. 1, und die Hauptbestandteile der Einrichtung sind mit gleichen Bezugszahlen wie dort bezeichnet. Auch bezüglich des Verfahrens gilt generell das bereits Gesagte. Es bestehen jedoch gewisse zweckmässige Abweichungen, die nachstehend erläutert werden:

Zum einen wird gemäss Fig. 9 für das Formiergas (Schutzgas) eine Zwangsströmung durch den vom festen Lot 1 durchlaufenen Raum 15' aufrechterhalten. Zu diesem Zweck weist die Führungsanordnung ein zusätzliches, innerhalb des Rohres 15 mit Abstand zu dessen Innenbohrung angeordnetes Rohr 70 auf. Das Formiergas oder Schutzgas wird über eine Bohrung 71 im Anschlussteil 14 in den Ringkanal zwischen den Rohren 70 und 15 und in diesem nach unten zum Ringraum 15' geleitet. Von dort strömt das Gas entlang dem Lotdraht 1 in der Führungsbohrung des Rohres 70 nach oben und wird über eine Bohrung 72 abgesaugt. Indem auf diese Weise ein Unterdruck im Ringraum 15' erzeugt wird, werden jegliche Fremdgase, insbesondere Sauerstoff, von der Lotschmelze und dem gegen die beheizte Zone geführten Lotdraht ferngehalten; so werden Fremdgase, die etwa oben beim Eintritt des Drahtes 1 oder im Gleitspalt zwischen dem Führungsrohr 20 und dem unteren Teil des Rohres 15 eindringen könnten, laufend freigespült. Dabei ist von Bedeutung, dass dadurch kein allzu hoher Gasdruck im Raum 15' entsteht, da dieser entlang dem Draht 1 auf die Schmelze 1' wirken und damit die Halte- und Ausstossvorgänge der Schmelze stören könnte.

Das bereitgestellte Volumen an flüssigem Lot 1' im Rohr 20 ist bei der Anordnung nach Fig. 1, wie dort erwähnt, gegeben durch den kontrollierten Vertikalabstand des Temperaturübergangs fest/flüssig über der Austrittsmündung 62 und den Durchmesser des Lotdrahtes 1, der dem Durchmesser der (zylindrischen) Bohrung 21 entspricht. Dieser Vertikalabstand kann zwar, wie ebenfalls ausgeführt, auf verschiedener Höhe eingestellt, aber wegen dem mit der Höhe zunehmenden metallostatischen Druck nicht beliebig hoch gewählt werden. Das Flüssigvolumen kann grundsätzlich durch Verwendung grösserer Drahtdurchmesser erhöht werden, doch sind praktische Grenzen dadurch gesetzt, dass der Draht in Spulenform geliefert wird. Hingegen lässt sich gemäss Fig.9 das Volumen der bereitstehenden Schmelze bei Bedarf massgeblich dadurch vergrössern, dass die Bohrung 21 in einem unteren Teil des beheizten Bereiches eine Erweiterung 21a aufweist. Durch diese Massnahme wird weder der metallostatische Druck auf die Austrittsmündung 62 erhöht noch die Dichtwirkung des festen Drahtes als "Kolben" beeinträchtigt.

Beim Ausführungsbeispiel nach Fig. 9 ist schliesslich anstelle eines Formstempels 6 ein Körper 6a vorgesehen, der jedoch in gleicher Weise auswechselbar gegen das untere Ende des Führungsrohres bzw. gegen die Kugelfläche des Tiegels 26 gehalten ist. Der durchbohrte Körper 6a bildet wiederum die verengte Austrittsmündung 62, durch die das flüssige Lot ausgestossen wird. Eine solche Ausführung wird zweckmässigerweise gewählt für die weiter oben erwähnten Verfahrensvarianten ohne Verwendung eines Formstempels (Absetzen von ausgestossenen Tropfen auf ein Substrat, bzw. "schreibender" Lotauftrag mit während dem Ausstossen bewegter Einrichtung). Wie leicht erkennbar, wird ein solcher Körper 6a mit der gleichen Anordnung wie ein Formstempel gehalten und ist auf dieselbe einfache Weise auswechselbar.

Es wurde bereits beim ersten Ausführungsbeispiel erwähnt, dass die ausgetragene Lotportion jeweils innerhalb der Bohrung 62 abreisst. Die Trennstelle innerhalb der Länge der Bohrung ist dabei unbestimmt, was eine gewisse Streuung in der Grösse der aufeinanderfolgenden Portionen bedeutet. Zwecks genauerer Dosierung kann diese Streuung vermindert werden, indem die Bohrung 62 verkürzt wird, insbesondere nach Fig. 10, wonach die Bohrung bei 62a von oben her aufgeweitet ist. Dadurch ist sichergestellt, dass die Schmelze nur im kurzen Bohrungsstück 62 abreissen kann. Die Massnahme nach Fig. 10 ist selbstverständlich gleichermassen für Körper 6a nach Fig. 9 wie auch für Formstempel 6 geeignet.

## Patentansprüche

1. Verfahren zum Austragen von flüssigem Lot in einzelnen Portionen, wobei festes Lot (1) in Draht- oder Stangenform in einer Führungsanordnung durch eine Längsbohrung schrittweise vorgeschoben, aufgeschmolzen und schmelzflüssig aus einer verengten Austrittsmündung ausgestossen wird,
dadurch **gekennzeichnet,** dass man an einem durchgehenden, im wesentlichen vertikalen Führungsrohr (20) einen vorderen, das Rohrende umfassenden Bereich (x) beheizt und einen rückwärtig anschliessenden Bereich (y) des Rohres kühlt, um längs des Rohres einen lagestabilen Temperaturübergang von unterhalb Solidustemperatur des Lotmaterials auf eine Temperatur, bei der das Lotmaterial mindestens teilweise schmelzflüssig ist, zu erzeugen, und dass man den Füllstand der Schmelze und damit die in der Bohrung (21) des Rohres jeweils vor dem Ausstossen bereitstehende Schmelzemenge durch den Vertikalabstand des genannten Temperaturübergangs zur verengten Austrittsmündung kontrolliert.

2. Verfahren nach Anspruch 1, dadurch gekennzeichnet, dass man bei konstanter Kühlleistung die Heiztemperatur des Führungsrohres (20) entsprechend der Schmelztemperatur des Lotmaterials regelt.

3. Verfahren nach Anspruch 1 oder 2, dadurch gekennzeichnet, dass man in der Bohrung (21) des Rohres über dem aufgeschmolzenen Lot (1') eine Schutzgas- oder Formiergas-Atmosphäre aufrechterhält.

4. Verfahren nach Anspruch 3, dadurch gekennzeichnet, dass man durch einen vom festen Lot durchlaufenen, mit der Bohrung (21) kommunizierenden Ringraum (15') der Führungsanordnung hindurch eine Zwangsströmung von Schutzgas oder Formiergas erzeugt.

5. Verfahren nach Anspruch 1, zum Auftragen von Lotportionen auf ein Substrat, dadurch gekennzeichnet, dass man einen an das Rohr (20) anschliessenden Formstempel (6), der einen mit der Austrittsmündung (22) kommunizierenden und gegen das Substrat (4) hin offenen Formhohlraum (61) aufweist, auf das Substrat (4) aufsetzt, die Lotportion (1") ausstösst und anschliessend den Formstempel (6) vom Substrat (4) abhebt.

6. Verfahren nach Anspruch 5, dadurch gekennzeichnet, dass man mit dem Ausstossen der Lotportion (1") beginnt, bevor der Formstempel (6) auf dem Substrat (4) aufsitzt.

7. Verfahren nach Anspruch 5 oder 6, wobei ein Formstempel (6) mit vom Formhohlraum (61) ausgehenden Steigerkanälen (63) verwendet wird, dadurch gekennzeichnet, dass man die Volumina der Lotportionen (1"), des Formhohlraumes (61) und der Steigerkanäle (63) so aufeinander abstimmt, dass beim Ausstossen der Lotportionen (1'') eine Teilmenge des Lotes in die Steigerkanäle (63) aufsteigt, um nach dem Abheben des Formstempels auf die vom Lot benetzte Substratfläche zurückzufliessen.

8. Verfahren nach einem der Ansprüche 5 bis 7, zum Montieren von Halbleiter-Chips (8) auf einem metallischen Substratstreifen (4), dadurch gekennzeichnet, dass man taktweise den Formstempel (6) auf den beheizten Substratstreifen (4) aufsetzt, die Lotportion (1") ausstösst, den Formstempel vom Substratstreifen und von der Lotportion abhebt, den Substratstreifen in Längsrichtung (c) vorschiebt und einen Halbleiter-Chip (8) auf der Lotportion (1") plaziert.

9. Verfahren nach einem der Ansprüche 1 bis 4, zum Auftragen von Lotportionen auf ein Substrat, dadurch gekennzeichnet, dass man an der Austrittsmündung (22) einen Tropfen flüssigen Lots bildet und die Mündung dem Substrat annähert, bis der Tropfen das Substrat berührt und von diesem aufgenommen wird.

10. Verfahren nach einem der Ansprüche 1 bis 4, zum Auftragen von Lotportionen auf ein Substrat, dadurch gekennzeichnet, dass man das feste Lot (1) impulsartig vorschiebt, um flüssige Lotportionen strahlartig gegen das Substrat auszustossen.

11. Einrichtung zur Durchführung des Verfahrens nach einem der Ansprüche 1 bis 10,
mit einer Führungsanordnung zur Längsführung von draht- oder stangenförmigem Lot (1), die ein im wesentlichen vertikales, beheiztes Führungsrohr (20) und eine verengte Austrittsmündung (62) für flüssiges Lot (1') aufweist,
und mit am Lot (1) angreifenden Antriebsmitteln (3) für dessen schrittweisen Vorschub in Richtung der Austrittsmündung,
dadurch **gekennzeichnet**,
dass zum Aufschmelzen des Lotes vorhandene Heizmittel (25, 26) zur Wärmezufuhr in einem das Austrittsende (22) des Führungsrohres (20) umfassenden Bereich (x) angeordnet sind,
und dass Kühlmittel (51, 52, 53) für das Führungsrohr (20) vorhanden sind, die einen an den beheizten Bereich (x) anschliessenden Bereich (y) des Führungsrohres (20) unter die Solidustemperatur des Lotes kühlen.

12. Einrichtung nach Anspruch 11, gekennzeichnet durch einen durchbohrten, auswechselbar gegen das Austrittsende (22) des Führungsrohres (20) gehaltenen und zusammen mit diesem beheizten Teil (6, 6a), dessen Bohrung (62,62a) die verengte Austrittsmündung (62) bildet.

13. Einrichtung nach Anspruch 12, zum Auftragen von Lotportionen (1") auf ein Substrat (4), dadurch gekennzeichnet, dass der auswechselbar gehaltene Teil ein Formstempel (6) ist, der aus einem vom geschmolzenen Lot (1') nicht benetzbaren Material besteht und der einen Formhohlraum (61) aufweist, der gegen das Substrat (4) hin offen ist und dessen Eingusskanal (62) mit der Bohrung (21) des Führungsrohres (20) in Verbindung steht, wobei Führungsrohr (20) und Formstempel (6) zusammen bezüglich des Substrats (4) heb- und senkbar sind.

14. Einrichtung nach Anspruch 12 oder 13, dadurch gekennzeichnet, dass der auswechselbare Teil bzw. der Formstempel (6, 6a) das Austrittsende (22) entlang einer Kugelfläche (24) berührt und bezüglich dieser kardanisch gelagert ist.

15. Einrichtung nach Anspruch 13, dadurch gekennzeichnet, dass der Formstempel (6) Steiger-Kanäle (63) für das geschmolzene Lot (1') aufweist, die vom Formhohlraum (61), vorzugsweise von Eck- oder Randbereichen desselben, ausgehen und deren Speicher volumen einen Teil des auszutragenden Lotes aufzunehmen vermag.

16. Einrichtung nach Anspruch 11, dadurch gekennzeichnet, dass der zu kühlende Bereich (y) des Führungsrohres (20) von einem Ringraum (52) umgeben ist, der von einem Kühlgas längsdurchströmt ist.

17. Einrichtung nach einem der Ansprüche 11 bis 16, dadurch gekennzeichnet, dass die Bohrung (21) des Führungsrohres (20) in einem unteren Teil des beheizten Bereiches (x) eine Flüssiglot (1') aufnehmende Erweiterung (21a) aufweist.

18. Einrichtung nach Anspruch 12 oder 13, dadurch gekennzeichnet, dass die Bohrung (62, 62a) auf der der Austrittsmündung des auswechselbaren Teils bzw. Formstempels (6; 6a) abgewandten Seite aufgeweitet ist.

## Claims

1. Method of dispensing liquid solder in separate portions, in which solid solder (1) in wire or rod form is fed step by step within a guidance system through a longitudinal bore, melted and ejected in molten form through a narrowed outlet, characterized in that a forward zone (x) including the end of a continuous, at least approximately vertical guide tube (20) is heated and an adjacent rear zone (y) of the tube is cooled, thereby maintaining along said tube a positionally stable temperature transition from below the solidus temperature of the solder material to a temperature at which the solder material is at least partially molten and liquid, so as to control within the bore (21) of the tube (20) the level of molten material and thereby the mass of molten material available for ejection in accordance with the vertical distance of said temperature transition from the narrowed outlet.

2. Method in accordance with claim 1, characterized in that at constant cooling power the temperature to which the guide tube (20) is heated is controlled in accordance with the solder material's melting temperature.

3. Method in accordance with claim 1 or 2, characterized in that an atmosphere of protective gas or forming gas is maintained in the bore (21) of the tube above the molten solder (1').

4. Method in accordance with claim 3, characterized in that a flow of protective gas or forming gas is forced across an annular space (151) communicating with the bore (21) of the guidance system through which the solid solder passes.

5. Method in accordance with claim 1 for applying portions of solder to a substrate, characterized in that a moulding die (6) adjacent to the tube (20), having a moulding cavity (61) communicating with the outlet (22) and open towards the substrate (4), is placed upon the substrate (4), the portion of solder (1") is ejected, and the moulding die (6) is then raised again from the substrate (4).

6. Method in accordance with claim 5, characterized in that ejection of the portion of solder (1") begins before the moulding die (6) comes to rest on the substrate (4).

7. Method in accordance with claim 5 or 6, wherein a moulding die (6) with vent holes (63) rising from its moulding cavity (61) is used, characterized in that the volumes of the portions of solder (1"), of the moulding cavity (61) and of the vent holes (63) are so matched with one another that upon ejection of the portions of solder (1") a part of the solder rises up the vent holes (63), in order to flow back upon the area of the substrate wetted by solder when the moulding die is raised.

8. Method in accordance with one of the claims 5 to 7, for the bonding of semiconductor chips (8) on a strip of a metallic substrate (4), characterized in that the moulding die (6) is cyclically set upon the heated strip of substrate (4), the portion of solder (1") is ejected, the moulding die is raised from the strip of substrate and from the portion of solder, the strip of substrate is moved forward lengthwise (c), and a semiconductor chip (8) is placed on the portion of solder (1").

9. Method in accordance with one of claims 1 to 4, for the application of portions of solder to a substrate, characterized in that a drop of liquid solder is formed at the outlet (22) and the outlet is brought close to the substrate until the drop touches the substrate and adheres thereto.

10. Method in accordance with one of claims 1 to 4, for the application of portions of solder to a substrate, characterized in that the solid solder (1) is advanced in a pulselike manner, in order to eject portions of liquid solder towards the substrate jet-like.

11. Apparatus for carrying out the method of one of claims 1 to 10, having a guidance system for lengthwise guiding solid solder (1) in the form of wire or rod, which comprises a heated, essentially vertical guide tube (20) and a narrowed outlet (62) for liquid solder (1'), and having a drive mechanism (3) acting upon the solder (1) for advancing it step by step towards the outlet, characterized in that heater means (25, 26) for melting the solder material are arranged for heat supply to a zone (x) of the guide tube (20) including said outlet (22), and in that cooling means (51, 52, 53) are provided for the guide tube (20) to cool a zone (y) of the guide tube (20) adjacent to said zone (x) to a temperature below the solidus temperature of the solder material.

12. Apparatus in accordance with claim 11, characterized by a drilled-through component (6, 6a) which is interchangeably held in contact with the end (22) of the guide tube (20) and heated together with it, the hole (62, 62a) of which forms the narrowed outlet (62).

13. Apparatus in accordance with claim 12, for the application of portions of solder (1") upon a substrate (4), characterized in that the interchangeably held component is a moulding die (6) made of a material non-wettable by molten solder (11) and having a moulding cavity (61) open towards the substrate (4), the gate or sprue (62) of which communicates with the hole (21) of the guide tube (20), wherein guide tube (20) and moulding die (6) can be raised and lowered together relative to the substrate (4).

14. Apparatus in accordance with claim 12 or 13, characterized in that the interchangeably held component or the moulding die (6, 6a), respectively, touches the outlet (22) of the tube (20) along a spherical surface (24) and is suspended on a gimbal mount in relation thereto.

15. Apparatus in accordance with claim 13, characterized in that the moulding die (6) has vertical vent holes (63) for the molten solder (1') which rise from the moulding die's cavity (61) preferably in its comers or along the edges thereof and the storage volume of which can receive a part of the solder to be dispensed.

16. Apparatus in accordance with claim 11, characterized in that the zone (y) of the guide tube (20) to be cooled is surrounded by an annular space (52) through which a cooling gas circulates lengthwise.

17. Apparatus in accordance with one of claims 11 to 16, characterized in that the bore (21) of the guide tube (20) has a widened part (21a) in the lower portion of the heated zone (x) for taking up liquid solder (1').

18. Apparatus in accordance with claim 12 or 13, characterized in that the hole (62, 62a) is widened on the side of the outlet of the interchangeable component or moulding die (6; 6a), respectively, opposing the outlet.

## Revendications

1. Procédé pour l'applicage de soudure liquide en portions individuelles avec lequel de la soudure solide (1) sous forme de fil ou de barre est entraînée pas à pas dans un dispositif de guidage au travers d'une ouverture de passage longitudinale, mis en fusion et éjecté en fusion à partir d'un orifice de sortie rétréci, caractérisé en ce que sur un tube de guidage (20) continu et essentiellement vertical une zone avant (x) entourant l'extrémité du tube est chauffée et qu'une zone adjacente arrière (y) du tube est refroidie pour créer le long du tube une transition de température stable depuis un niveau de température inférieur à celui du passage à l'état solide de la soudure jusqu'à une température sous laquelle la soudure est au moins partiellement en fusion et que le niveau de remplissage en soudure en fusion et de ce fait le volume de soudure en fusion respectivement disponible avant l'éjection dans l'ouverture de passage (21) du tube est contrôlé au moyen de l'écart vertical de la transition de température indiquée par rapport à l'orifice de sortie rétréci.

2. Procédé selon la revendication 1, caractérisé en ce que pour une capacité de refroidissement constante, la température de chauffage du tube de guidage (20) est régulée conformément à la température de fusion de la soudure.

3. Procédé selon la revendication 1 ou 2, caractérisé en ce qu'une atmosphère de gaz de protection ou de mélange hydrogène-azote est maintenue dans l'ouverture de passage (21) du tube au-dessus de la soudure en fusion (1').

4. Procédé selon la revendication 3, caractérisé en ce qu'un flux forcé de gaz de protection ou de mélange hydrogène-azote est envoyé au travers d'un compartiment circulaire (15') de la configuration de guidage dans lequel passe la soudure solide et qui communique avec l'ouverture de passage (21).

5. Procédé selon la revendication 1 pour l'applicage de portions de soudure sur un substrat, caractérisé en ce qu'un moule de formage (6) attenant au tube (20) comportant une cavité creuse profilée (61), communiquant avec l'orifice de sortie (22) et ouverte en direction du substrat (4) est mis en place sur le substrat (4), que la portion de soudure (1") est éjectée et qu'ensuite le moule de formage (6) est enlevé du substrat (4).

6. Procédé selon la revendication 5, caractérisé en ce que l'éjection de la portion de soudure (1") commence avant que le moule de formage (6) ne soit placé sur le substrat (4).

7. Procédé selon la revendication 5 ou 6 utilisant un moule de formage (6) avec des conduits de remontée (63) partant de la cavité creuse profilée (61), caractérisé en ce que les volumes des portions de soudure (1"), de la cavité creuse profilée (61) et des conduits de remontée (63) sont accordés entre eux de telle manière que lors de l'éjection des portions de soudure (1") une quantité partielle de la soudure remonte dans les conduits de remontée (63) pour, après l'enlèvement du moule de formage, s'écouler de nouveau sur la surface du substrat ayant reçu un dépôt de soudure.

8. Procédé selon l'une des revendications 5 à 7 pour le montage de puces de semi-conducteurs (8) sur une bande de substrat métallique (4), caractérisé en ce que le moule de formage (6) est placé de manière cadencée sur la bande de substrat chauffée (4), que la portion de soudure (1") est éjectée, que le moule de formage est dégagé de la bande de substrat et de la portion de soudure, que la bande de substrat est entraînée en direction (c) et qu'une puce de semiconducteur (8) est placée sur la portion de soudure (1").

9. Procédé selon l'une des revendications 1 à 4 pour l'applicage de portions de soudure sur un substrat, caractérisé en ce qu'une goutte de soudure liquide est constituée à l'orifice de sortie (22) et que l'orifice est rapproché du substrat jusqu'à ce que la goutte touche le substrat et soit absorbée par celui-ci.

10. Procédé selon l'une des revendications 1 à 4 pour l'applicage de portions de soudure sur un substrat, caractérisé en ce que la soudure solide (1) est entraînée par impulsions pour éjecter des portions de soudure liquide par jets contre le substrat.

11. Dispositif pour la réalisation du procédé selon l'une des revendications 1 à 10, avec une configuration de guidage pour le guidage longitudinal de soudure sous forme de fil ou de barre (1) comportant un tube de guidage (20) placé pour l'essentiel en position verticale et chauffé et un orifice de sortie rétréci (62) pour la soudure liquide (1'), et avec des systèmes d'entraînement(3) agissant sur la soudure (1) pour un entraînement pas à pas de ce dernier en direction de l'orifice de sortie, caractérisé en ce que des éléments de chauffage (25, 26) servant à la mise en fusion de la soudure sont disposés dans une zone (x) entourant l'extrémité de sortie (22) du tube de guidage (20) pour assurer l'alimentation en chaleur et qu'il existe des éléments de refroidissement (51, 52, 53) pour le tube de guidage (20) qui refroidissent une zone (y) du tube de guidage (20) attenante à la zone chauffée (x) à une température inférieure à la température de passage à l'état solide de la soudure.

12. Dispositif selon la revendication 11, caractérisé par une partie (6, 6a) percée et maintenue de manière interchangeable contre l'extrémité de sortie (22) du tube de guidage (20) et chauffée en même temps que celui-ci, et dont l'ouverture de passage (62, 62a) constitue l'orifice de sortie rétréci (62).

13. Dispositif selon la revendication 12 pour l'applicage de portions de soudure (1") sur un substrat (4), caractérisé en ce que la partie maintenue de manière interchangeable est un moule de formage (6) qui se compose d'un matériau ne pouvant pas recevoir de dépôt de soudure en fusion (1') et qui comporte une cavité creuse profilée (61), qui est ouvert en direction du substrat (4) et dont le conduit de remplissage (62) est relié avec l'ouverture de passage (21) du tube de guidage (20), le tube de guidage (20) et le moule de formage (6) pouvant être levés et abaissés ensemble par rapport au substrat (4).

14. Dispositif selon la revendication 12 ou 13, caractérisé en ce que la partie interchangeable ou le moule de formage (6, 6a) est en contact avec l'extrémité de sortie (22) le long d'une surface sphérique (24) et fait l'objet d'une liaison à cardan par rapport à celle-ci.

15. Dispositif selon la revendication 13, caractérisé en ce que le moule de formage (6) est muni de conduits de remontée (63) pour la soudure en fusion (1') qui partent de la cavité creuse profilée (61), de préférence à partir de zones angulaires ou marginales de celle-ci, et dont le volume de stockage peut absorber une partie de la soudure à mettre en applicage.

16. Dispositif selon la revendication 11, caractérisé en ce que la zone à refroidir (y) du tube de guidage (20) est entourée d'un compartiment circulaire (52) qui est soumis au passage d'un flux de gaz de refroidissement en direction longitudinale.

17. Dispositif selon l'une des revendications 11 à 16, caractérisé en ce que l'ouverture de passage (21) du tube de guidage (20) comporte dans une partie inférieure de la zone chauffée (x) une extension (21a) absorbant de la soudure liquide (1').

18. Dispositif selon la revendication 12 ou 13, caractérisé en ce que l' ouverture de passage (62, 62a) est élargie à la face détournée de 1' orifice de sortie de la partie interchangeable ou du moule de formage (6; 6a), respectivement.
